# EUROPEAN PATENT APPLICATION

(11) **EP 2 787 540 A1**
(43) Date of publication of application: **08.10.2014**
(21) Application number: 14163168.9
(22) Date of filing: 02.04.2014
(51) Int. Cl.: H01L 31/048

(54) **Solar cell panel end-sealing composition, solar cell panel end-sealing sheet, and solar cell panel**

(30) Priority: 05.04.2013 JP 2013079856
(71) Applicant: NITTO DENKO CORPORATION, Ibaraki-shi, Osaka 567-8680 (JP)
(72) Inventor: Hayashi, Youhei, Osaka, 567-8680, (JP); Kiriyama, Akihiro, Osaka, 567-8680, (JP); Asano, Kazumasa, Osaka, 567-8680, (JP); Kose, Shinichiro, Osaka, 567-8680, (JP); Shirai, Masato, Osaka, 567-8680, (JP); Iseki, Toru, Osaka, 567-8680, (JP)
(74) Representative: Schwabe - Sandmair - Marx

(57) **Abstract**

A solar cell panel end-sealing composition contains a butyl rubber, a polyolefin resin having a silyl group, and a catalyst. The catalyst is at least one of a metal oxide, a metal hydroxide, and a metal complex of a transition element and the solar cell panel end-sealing composition has a flow viscosity at 140°C of 500 Pa·s or more and 8000 Pa·s or less.

## Description

### BACKGROUND OF THE INVENTION

### Field of the Invention

The present invention relates to a solar cell panel end-sealing composition, a solar cell panel end-sealing sheet, and a solar cell panel, to be specific, to a sealing composition used for the encapsulation of a solar cell panel, a solar cell panel end-sealing sheet formed from the sealing composition, and a solar cell panel in which an end thereof is encapsulated by the solar cell panel end-sealing sheet.

### Description of Related Art

In a solar cell panel, a solar cell element is disposed between two pieces of glass that are disposed in opposed relation to each other and a gap between the two pieces of glass is filled with an encapsulating resin. In the gap between the two pieces of glass, which is a circumference end portion of the encapsulating resin (an end of the glass), a sealing material is provided so as to prevent the infiltration of fluid such as water and moisture into the encapsulating resin and the solar cell element.

The sealing material is generally in a liquid state, so that the solar cell panel is sealed by applying and heating the sealing material to the end of the glass.

When a liquid sealing material is used, however, the glass is required to be prepared so as to have a specific thickness and width so that the liquid sealing material fails to protrude from the end and thus, the workability is poor.

Then, a method for sealing the solar cell panel easily and efficiently by using a sealing material in a sheet shape has been known (ref: for example, Japanese Unexamined Patent Publication No. 2011-231309).

In Japanese Unexamined Patent Publication No. 2011-231309, a sealing material prepared by forming a sealing composition into a sheet shape has been proposed. In the sealing composition, a rubber component and a polyolefin are contained; the rubber component contains a butyl rubber and a polyisobutylene having a viscosity average molecular weight of 500000 to 3000000; the mixing ratio of the rubber component with respect to 100 parts by weight of the total amount of the rubber component and the polyolefin is 40 to 90 parts by weight; and 0 to 30 parts by weight of a hygroscopic compound with respect to 100 parts by weight of the total amount of the rubber component and the polyolefin is contained.

### SUMMARY OF THE INVENTION

The further improvement of the sealing properties of the solar cell panel is still required. Thus, by blending a reactive additive or a reaction active material that reacts to a solar cell panel end such as glass into a sealing material, the improvement of the adhesive properties of the sealing material has been considered.

When the sealing material is stored, however, there is a disadvantage that a reaction caused by the additive is progressed at the inside of the sealing material, so that the adhesive force is reduced at the time of use of the sealing material.

It is an object of the present invention to provide a solar cell panel end-sealing composition, a solar cell panel end-sealing sheet, and a solar cell panel, each of which has excellent adhesive properties and excellent storage stability.

A solar cell panel end-sealing composition of the present invention contains a butyl rubber, a polyolefin resin having a silyl group, and a catalyst, wherein the catalyst is at least one of a metal oxide, a metal hydroxide, and a metal complex of a transition element and the solar cell panel end-sealing composition has a flow viscosity at 140°C of 500 Pa·s or more and 8000 Pa·s s or less.

In the solar cell panel end-sealing composition of the present invention, it is preferable that the polyolefin resin having a silyl group has a number average molecular weight of 5000 or more and 25000 or less.

In the solar cell panel end-sealing composition of the present invention, it is preferable that a metal constituting the metal oxide is at least one selected from the group consisting of magnesium, calcium, titanium, zirconium, iron, nickel, zinc, aluminum, and cerium.

In the solar cell panel end-sealing composition of the present invention, it is preferable that a metal constituting the metal hydroxide is at least one selected from the group consisting of magnesium, calcium, manganese, iron, copper, zinc, and aluminum.

In the solar cell panel end-sealing composition of the present invention, it is preferable that a metal constituting the metal complex of a transition element is at least one selected from the group consisting of titanium, zirconium, iron, and nickel.

In the solar cell panel end-sealing composition of the present invention, it is preferable that a silane coupling agent is further contained.

In the solar cell panel end-sealing composition of the present invention, it is preferable that a polyolefin resin failing to have a silyl group is further contained.

In the solar cell panel end-sealing composition of the present invention, it is preferable that the polyolefin resin failing to have a silyl group is at least one selected from the group consisting of polyethylene, polypropylene, and an ethylene-propylene copolymer.

A solar cell panel end-sealing sheet of the present invention is formed from the above-described solar cell panel end-sealing composition into a sheet shape.

A solar cell panel of the present invention includes a glass layer, a support layer disposed at spaced intervals to the glass layer in a thickness direction, a solar cell element and an encapsulating resin layer encapsulating the solar cell element provided between the glass layer and the support layer and disposed at the inside of ends of the glass layer and the support layer, and the above-described solar cell panel end-sealing sheet attached between the ends of the glass layer and the support layer so as to fix the glass layer and the support layer.

The solar cell panel end-sealing composition and the solar cell panel end-sealing sheet of the present invention have excellent adhesive properties and excellent storage stability. Thus, in the case of its use after long-term storage, the end of the solar cell panel is capable of being surely encapsulated.

In the solar cell panel of the present invention, the end of the solar cell panel is encapsulated by the sheet having excellent adhesive properties, so that a reduction in power generation efficiency is capable of being effectively prevented.

### BRIEF DESCRIPTION OF THE DRAWINGS

FIG. 1 shows a sectional view of one embodiment of a solar cell panel end-sealing sheet of the present invention.
FIGS. 2A to C show one embodiment of a solar cell panel of the present invention:

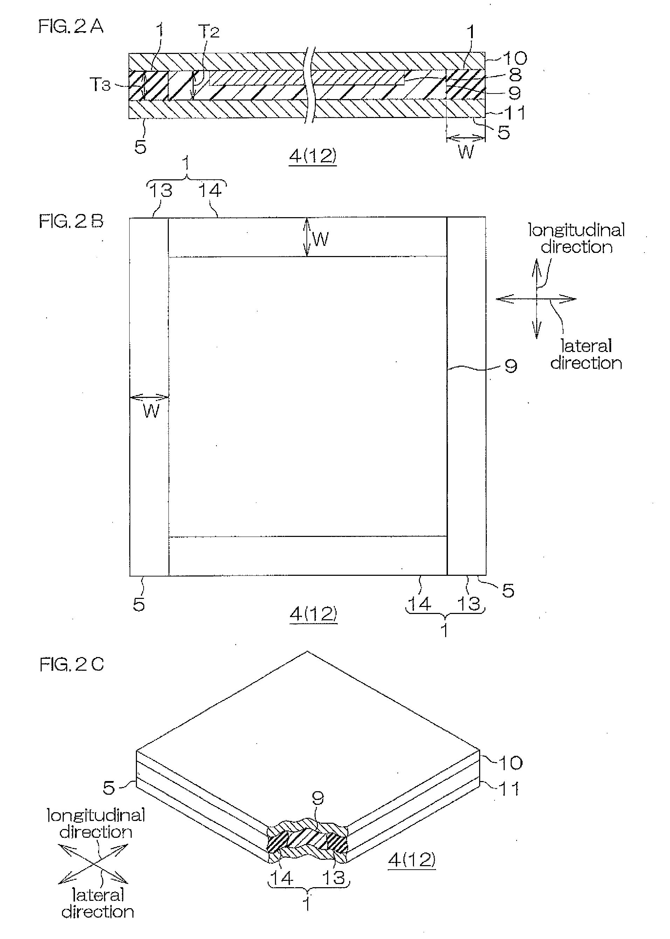

   FIG. 2A illustrating a sectional view,
   FIG. 2B illustrating a plan view, and
   FIG. 2C illustrating a partially cut-away sectional perspective view.

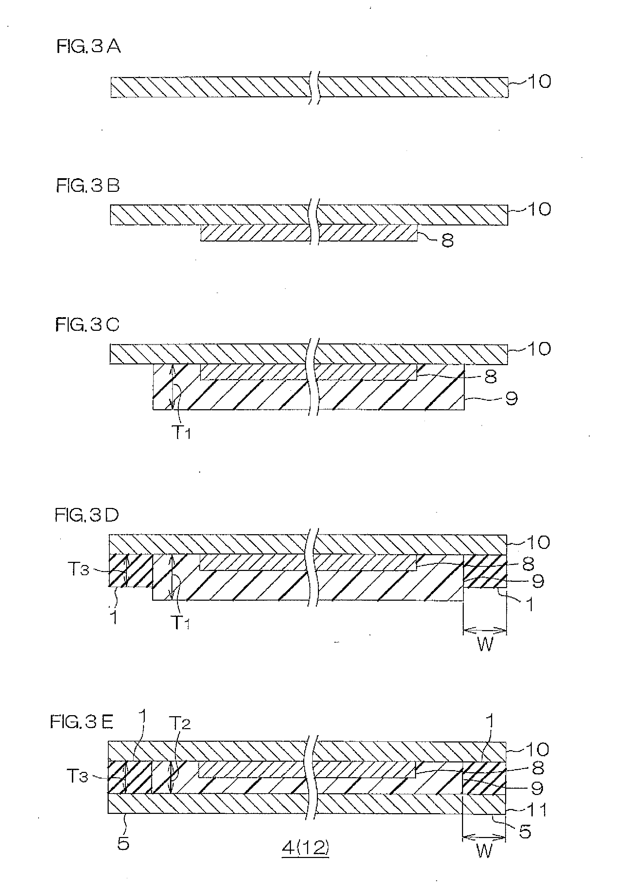

FIGS. 3A to E show process drawings for illustrating a method for producing the solar cell panel shown in FIG. 2A:
   FIG. 3A illustrating a step of preparing an upper-side glass layer,
   FIG. 3B illustrating a step of disposing a solar cell element,
   FIG. 3C illustrating a step of disposing an encapsulating resin layer,
   FIG. 3D illustrating a step of disposing a sealing sheet, and
   FIG. 3E illustrating a step of disposing a lower-side glass layer.

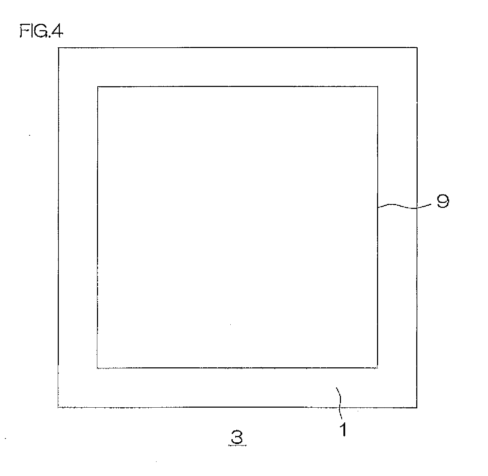

FIG. 4 shows a plan view of a solar cell module (an embodiment in which a sealing sheet is formed of one piece).

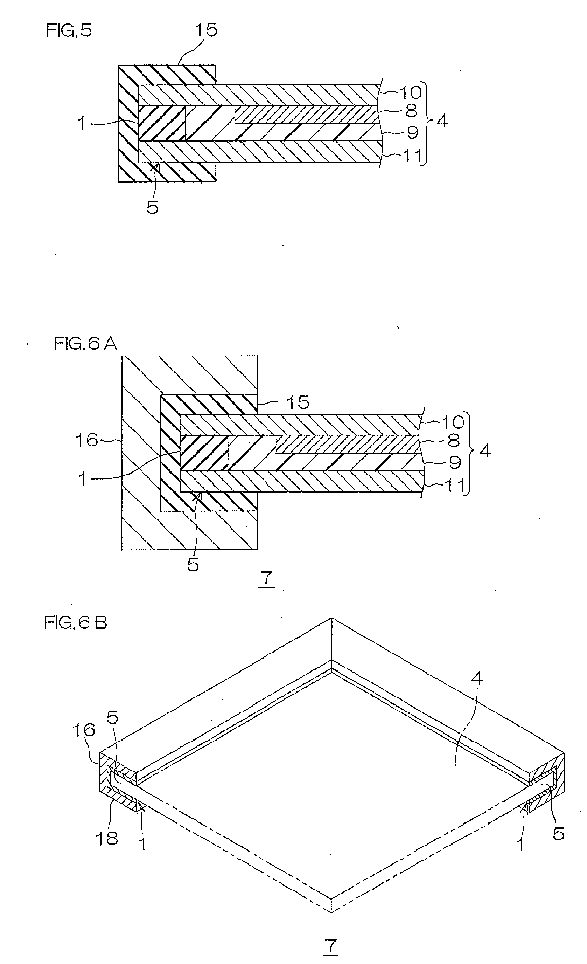

FIG. 5 shows a partially enlarged sectional view of a frameless solar cell module (a frameless solar cell module in which a second sealing material is provided) including the solar cell panel shown in FIGS. 2A to C.
FIGS. 6A to B show explanatory views of a solar cell module (a solar cell module in which a frame is provided) including the solar cell panel shown in FIGS. 2A to C:
   FIG. 6A illustrating a partially enlarged sectional view and
   FIG. 6B illustrating a partially sectional perspective view.

### DETAILED DESCRIPTION OF THE INVENTION

A sealing composition of the present invention is used for the encapsulation of various industrial products, or preferably for the encapsulation of a solar cell panel and contains a butyl rubber, a polyolefin resin having a silyl group, and a catalyst.

The butyl rubber is a copolymer (an isobutylene-isoprene rubber) of isobutene (isobutylene) and a small amount of isoprene.

The butyl rubber has a degree of unsaturation of, for example, 0.6 mol % or more, or preferably 0.7 mol % or more, and of, for example, 2.5 mol % or less, or preferably 2.0 mol % or less. The degree of unsaturation of the butyl rubber is measured by an iodine absorption method.

The butyl rubber has a Mooney viscosity of, for example, 20 (ML₁₊₈, 125°C) or more, or preferably 30 (ML₁₊₈, 125°C) or more, and of, for example, 70 (ML₁₊₈, 125°C) or less, or preferably 60 (ML₁₊₈, 125°C) or less.

The butyl rubber has a viscosity average molecular weight of, for example, 300000 or more, and of, for example, 700000 or less, or preferably 500000 or less.

The viscosity average molecular weight is measured in conformity with JIS K 7252 01 (in 2008) using standard polystyrene with a size exclusion chromatography (SEC). The viscosity average molecular weight to be described later is measured in the same manner.

The mixing ratio of the butyl rubber with respect to the sealing composition is, for example, 10 mass % or more, or preferably 15 mass % or more, and is, for example, 60 mass % or less, or preferably 50 mass % or less.

In the polyolefin resin having a silyl group, for example, the main chain is composed of a polymer of olefin and a side chain thereof has a silyl group.

An example of the silyl group includes an alkoxy silyl group such as a trialkoxy silyl group including a trimethoxy silyl group and a triethoxy silyl group, a dialkoxy silyl group including a methyl dimethoxy silyl group and an ethyl diethoxy silyl group, and a monoalkoxy silyl group such as a dimethyl methoxy silyl group and a diethyl ethoxy silyl group. Preferably, a trialkoxy silyl group is used.

As the olefin constituting the main chain, preferably, an α-olefin is used.

An example of the α-olefin includes an α-olefin having 2 to 6 (preferably 2 to 7) carbon atoms such as ethylene, propylene, 1-butene, isobutene, and 4-methyl-1-pentene.

These olefins can be used alone or in combination of two or more. That is, the olefin constituting the main chain may be a homopolymer or a copolymer.

Among these olefins, preferably, ethylene, propylene, 1-butene, 2-butene, isobutene, and the like are used.

When the polyolefin resin is a copolymer, for example, a random copolymer and a block copolymer are used.

The polyolefin resin contains, for example, a crystalline polyolefin.

The silyl group equivalent of the polyolefin resin having a silyl group with respect to 100 of the total number of the copolymerized monomer is, for example, 0.1 or more, or preferably 0.3 or more, and is, for example, 20 or less, or preferably 10 or less. By setting the silyl group equivalent within the above-described range, the adhesive properties are further improved.

The polyolefin resin having a silyl group has a number average molecular weight of, for example, 5000 or more, or preferably 10000 or more, and of, for example, 25000 or less, or preferably 15000 or less. The number average molecular weight is measured with polystyrene calibration using a gel permeation chromatography.

When the number average molecular weight is below the above-described lower limit, there may be a case where the compatibility with the butyl rubber is reduced and the polyolefin resin having a silyl group bleeds from a surface of a solar cell panel end-sealing sheet (hereinafter, may be abbreviated as a "sealing sheet"), so that the adhesive properties are poor. On the other hand, when the number average molecular weight is above the above-described upper limit, there may be a case where the dispersibility is poor, so that an insoluble material is generated at the time of kneading.

The polyolefin resin having a silyl group has a weight average molecular weight of, for example, 10000 or more, or preferably 35000 or more, and of, for example, 120000 or less, or preferably 100000 or less. The weight average molecular weight is measured with polystyrene calibration using a gel permeation chromatography.

The polyolefin resin having a silyl group has a softening point (a ring and ball test) of, for example, 50°C or more, or preferably 85°C or more, and of, for example, 150°C or less, or preferably 105°C or less.

To be specific, an example of the polyolefin resin having a silyl group includes the VESTOPLAST series manufactured by Evonik Industries AG.

The content ratio of the polyolefin resin having a silyl group with respect to 100 parts by mass of the butyl rubber is, for example, 5 parts by mass or more, or preferably 10 parts by mass or more, and is, for example, 500 parts by mass or less, or preferably 100 parts by mass or less. The content ratio thereof with respect to the sealing composition is, for example, 1 mass % or more, or preferably 3 mass % or more, and is, for example, 60 mass % or less, or preferably 50 mass % or less.

The sealing composition contains a catalyst.

Examples of the catalyst include a metal oxide, a metal hydroxide, and a metal complex of a transition element.

Examples of the metal constituting the metal oxide include magnesium, calcium, titanium, zirconium, iron, nickel, zinc, aluminum, and cerium. Preferably, zinc and titanium are used.

To be specific, examples of the metal oxide include magnesium oxide (MgO), calcium oxide (CaO), titanium dioxide (TiO₂), zirconium dioxide (ZrO₂), iron oxide (FeO, Fe₂O₃), nickel oxide (NiO), zinc oxide (ZnO), aluminum oxide (Al₂O₃), and cerium oxide (CeO₂). Preferably, titanium dioxide and zinc oxide are used, or more preferably, zinc oxide is used.

Examples of the metal constituting the metal hydroxide include magnesium, calcium, manganese, iron, copper, zinc, and aluminum. Preferably, aluminum is used.

To be specific, examples of the metal hydroxide include magnesium hydroxide (Mg(OH)₂), calcium hydroxide (Ca(OH)₂), manganese hydroxide (Mn(OH)₂), iron hydroxide (Fe(OH)₂), copper hydroxide (Cu(OH)₂), zinc hydroxide (Zn(OH)₂), and aluminum hydroxide (Al(OH)₃).

Examples of the metal constituting the metal complex of a transition element include titanium, zirconium, iron, and nickel. Preferably, zirconium is used.

Examples of a ligand constituting the metal complex include acetylacetone, pyridine, triphenylphosphine, acetate ion, halide ion, ammonia, carbon monoxide, ethylenediamine, bipyridine, phenanthroline, catecholato, terpyridine, ethylenediaminetetraacetic acid, porphyrin, cyclam, and crown ether. Preferably, acetylacetone is used.

Examples of the metal complex of a transition element include titanium (II) acetylacetone, zirconium (IV) acetylacetone, iron (III) acetylacetone, and nickel (II) acetylacetone.

Preferably, zirconium (IV) acetylacetone or the like is used.

The content ratio of the catalyst with respect to 100 parts by mass of the polyolefin resin having a silyl group is, for example, 0.1 parts by mass or more, or preferably 1 part by mass or more, and is, for example, 10 parts by mass or less, or preferably 5 parts by mass or less. The content ratio thereof with respect to the sealing composition is, for example, 0.01 mass % or more, or preferably 0.1 mass % or more, and is, for example, 1 mass % or less, or preferably 0.5 mass % or less.

The sealing composition and furthermore, the sealing sheet (described later) that is formed from the sealing composition have excellent adhesive properties and excellent storage stability by containing a specific catalyst illustrated in the description above. That is, when the sealing sheet is attached to the solar cell panel end to be sealed by, for example, thermocompression bonding, the above-described catalyst activates a reaction of the polyolefin resin having a silyl group with the solar cell panel end and as a result, the sealing sheet is further rigidly attached to the solar cell panel. The above-described specific catalyst has weak reactivity at a normal temperature, so that a reaction (gelation) of the polyolefin resins having a silyl group with themselves is suppressed at the time of storage under a normal temperature and thus, the storage stability is excellent.

The sealing composition preferably contains a silane coupling agent.

Examples of the silane coupling agent include an epoxy group-containing silane coupling agent such as 3-glycidoxypropyltrimethoxysilane, 3-glycidoxypropyltriethoxysilane, 3-glycidoxypropylmethyldiethoxysilane, and 2-(3,4-epoxycyclohexyl)ethyltrimethoxysilane; an amino group-containing silane coupling agent such as 3-aminopropyltrimethoxysilane, N-2-(aminoethyl)-3-aminopropylmethyldimethoxysilane, and 3-triethoxysilyl-N-(1,3-dimethylbutylidene)propylamine; a (meth)acryl group-containing silane coupling agent such as 3-acryloxypropyltrimethoxysilane and 3-methacryloxypropyltriethoxysilane; and an isocyanate group-containing silane coupling agent such as 3-isocyanatepropyltriethoxysilane. These silane coupling agents can be used alone or in combination of two or more.

Among these silane coupling agents, in view of adhesive properties and storage stability, preferably, an epoxy group-containing silane coupling agent is used.

When the sealing composition contains a silane coupling agent, the content ratio of the silane coupling agent with respect to 100 parts by mass of the polyolefin resin having a silyl group is, for example, 0.1 parts by mass or more, or preferably 1 part by mass or more, and is, for example, 15 parts by mass or less, or preferably 10 parts by mass or less. The content ratio thereof with respect to the sealing composition is, for example, 0.01 mass % or more, or preferably 0.1 mass % or more, and is, for example, 2 mass % or less, or preferably 1 mass % or less.

The sealing composition preferably contains a polyolefin resin that fails to have a silyl group. In this manner, the formability into the sealing sheet is excellent and the adhesive properties of the sealing sheet are further improved.

Examples of the polyolefin resin that fails to have a silyl group include polyethylene (for example, low-density polyethylene such as linear low-density polyethylene, medium-density polyethylene, and high-density polyethylene), polypropylene, and an ethylene-propylene copolymer. Examples of the polyolefin resin include a polyisobutylene, a copolymer of ethylene or propylene with other α-olefins, and a copolymer of ethylene with an oxide-containing ethylenically unsaturated monomer.

The polyisobutylene is a polymer of isobutylene. The polyisobutylene has a viscosity average molecular weight of, for example, 500000 or more, or preferably 700000 or more, and of, for example, 3000000 or less, or preferably 2000000 or less.

An example of the other α-olefins includes an α-olefin having 4 to 7 (preferably, 4 to 6) carbon atoms such as 1-butene, 1-pentene, 1-hexene, and 4-methyl-1-pentene.

Examples of the oxide-containing ethylenically unsaturated monomer include vinyl acetate, acrylic acid, acrylate, methacrylic acid, methacrylate, and vinyl alcohol.

When the polyolefin resin that fails to have a silyl group is a copolymer, for example, a random copolymer and a block copolymer are used.

The polyolefin resin that fails to have a silyl group contains, for example, a crystalline polyolefin.

The polyolefin resin that fails to have a silyl group has a softening point (a ring and ball test) of, for example, 100°C or more, or preferably 110°C or more, and of, for example, 150°C or less, or preferably 140°C or less.

These polyolefin resins that fail to have a silyl group can be used alone or in combination of two or more.

Among the polyolefin resins that fail to have a silyl group, preferably, polyethylene, polypropylene, an ethylene-propylene copolymer, a polyisobutylene, and the like are used, or more preferably, polyethylene, polypropylene, and an ethylene-propylene copolymer are used.

The mixing ratio of the polyolefin resin that fails to have a silyl group with respect to 100 parts by mass of the butyl rubber is, for example, 10 parts by mass or more, or preferably 20 parts by mass or more, and is, for example, 200 parts by mass or less, or preferably 100 parts by mass or less. The mixing ratio thereof with respect to the sealing composition is, for example, 1 mass % or more, or preferably 5 mass % or more, and is, for example, 30 mass % or less, or preferably 20 mass % or less.

Also, for example, fillers, tackifiers, lubricants, and oxidation inhibitors can be blended into the sealing composition.

An example of the filler includes an inorganic filler such as a pigment (for example, an inorganic pigment). To be specific, examples of the inorganic filler include calcium carbonate (for example, heavy calcium carbonate or light calcium carbonate), talc, carbon black, and silica. Preferably, calcium carbonate and carbon black are used. These fillers can be used alone or in combination of two or more.

The filler has an average particle size of, for example, 1 nm or more, or preferably 10 nm or more, and of, for example, 1000 µm or less, or preferably 100 µm or less.

The mixing ratio of the filler with respect to the sealing composition is, for example, 10 mass % or more, or preferably 15 mass % or more, and is, for example, 60 mass % or less, or preferably 50 mass % or less. When the mixing ratio of the filler is within the above-described range, the flow viscosity of the sealing composition is capable of being set within an excellent range and as a result, a solar cell panel end-sealing sheet having excellent adhesive properties and excellent storage stability is capable of being obtained.

Examples of the tackifier include a petroleum resin and a hydrocarbon-based resin (for example, a C5-hydrocarbon-based resin, a phenol-based resin, a rosin-based resin, a terpene-based resin, and a coumarone-based resin). An example of the tackifier also includes a low molecular weight polyisobutylene. These tackifiers can be used alone or in combination of two or more.

As the tackifier, preferably, a terpene-based resin, a coumarone-based resin, and a low molecular weight polyisobutylene are used, or more preferably, a terpene-based resin and a low molecular weight polyisobutylene are used in combination or a coumarone-based resin and a low molecular weight polyisobutylene are used in combination.

The terpene-based resin has a softening point (a deflection temperature under load) of, for example, 90°C or more, or preferably 100°C or more, and of, for example, 140°C or less, or preferably 130°C or less.

The coumarone-based resin has a softening point (a deflection temperature under load) of, for example, 90°C or more, or preferably 100°C or more, and of, for example, 140°C or less, or preferably 130°C or less.

The low molecular weight polyisobutylene has a viscosity average molecular weight of, for example, less than 300000, to be specific, for example, 10000 or more, or preferably 30000 or more, and of, for example, 250000 or less, or preferably 60000 or less.

The mixing ratio of the tackifier with respect to the sealing composition is, for example, 0.1 mass % or more, or preferably 1 mass % or more, and is, for example, 25 mass % or less, or preferably 15 mass % or less.

Examples of the lubricant include stearic acid and esters thereof and a stearic acid-based compound such as zinc stearate. These lubricants can be used alone or in combination of two or more.

The mixing ratio of the lubricant with respect to the sealing composition is, for example, 0.01 mass % or more, or preferably 0.1 mass % or more, and is, for example, 3 mass % or less, or preferably 1 mass % or less.

Examples of the oxidation inhibitor include a hindered phenol-based antioxidant (for example, pentaerythrityl-tetrakis[3-(3,5-di-t-butyl-4-hydroxyphenyl)propionate]), a benzimidazole-based antioxidant, an amine-ketone-based antioxidant, an aromatic secondary amine-based antioxidant, a thiourea-based antioxidant, and a phosphorous acid-based antioxidant. These oxidation inhibitors can be used alone or in combination of two or more.

The mixing ratio of the oxidation inhibitor with respect to the sealing composition is, for example, 0.01 mass % or more, or preferably 0.1 mass % or more, and is, for example, 3 mass % or less, or preferably 1 mass % or less.

Furthermore, for example, additives such as other pigments (organic pigments), antistatic agents, plasticizers, thermal stabilizers, foaming agents, and other fillers (organic fillers) can be added to the sealing composition at an appropriate proportion as required.

The above-described components are blended at the above-described mixing proportion to be heated and kneaded, so that the sealing composition of the present invention is capable of being obtained as a kneaded material.

At this time, preferably, among the above-described components, the components other than the catalyst are blended at the above-described mixing proportion to be heated and kneaded, so that a first kneaded material is prepared (a first kneading step). Next, after cooling the prepared first kneaded material, the catalyst is blended into the first kneaded material at the above-described mixing proportion to be kneaded, so that a second kneaded material is prepared (a second kneading step).

In the kneading, for example, a batch type kneader such as a kneader, a banbury mixer, and a mixing roll and a continuous kneader such as a biaxial kneader are used.

The heating temperature in the first kneading step is, for example, 100°C or more, or preferably 120°C or more, and is, for example, 200°C or less, or preferably 150°C or less.

The heating temperature in the second kneading step is, for example, 50°C or more, or preferably 60°C or more, and is, for example, less than 100°C, or preferably 90°C or less.

By setting the heating temperature in the second kneading step lower than that in the first kneading step, the catalytic activity before the use of the sealing sheet is capable of being suppressed, so that the storage stability is capable of being further improved.

The sealing composition obtained in this manner has a flow viscosity of 500 Pa·s or more and 8000 Pa·s or less. Preferably, the sealing composition has a flow viscosity of 1000 Pa·s or more and 3000 Pa·s or less. When the flow viscosity of the sealing composition is above the above-describe upper limit, the adhesive force of the sealing sheet that is formed from the sealing composition is poor. On the other hand, when the flow viscosity of the sealing composition is below the above-described lower limit, the formation thereof into a sheet shape becomes difficult and the rewinding properties of a roll-shaped sheet after long-term storage become difficult. The flow viscosity is measured in conformity with JIS K 7210 (test conditions: a load of 20 kg (21 kgf/cm²), a measurement temperature of 140°C) using a flowability evaluation device ("Flowtester CFT-500D", manufactured by Shimadzu Corporation").

By forming the sealing composition into a sheet shape, the sealing sheet (the sealing material) of the present invention is capable of being obtained.

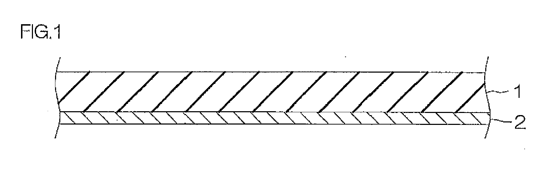

Next, a sealing sheet that is prepared from the sealing composition of the present invention is described with reference to FIG. 1.

The sealing composition obtained by the above-described manner is heated with, for example, a molding device such as an extruder, a calender roll, and a pressing device (a hot pressing device) and is formed into a sheet shape to be laminated on the surface of a release film 2.

The heating temperature at this time is, for example, 50°C or more, or preferably 60°C or more, and is, for example, less than 100°C, or preferably 90°C or less.

The pressure to be pressurized at this time is, for example, 1 kPa or more, or preferably 10 kPa or more, and is, for example, 200 kPa or less, or preferably 100 kPa or less.

The duration to be pressurized at this time is, for example, 10 seconds or more, or preferably 30 seconds or more, and is, for example, one hour or less, or preferably 30 minutes or less.

In this manner, a sealing sheet (a first sealing material) 1 is obtained.

The sealing sheet 1 is formed into a long-length wide and flat-belt shape extending in a lengthwise direction. As shown in FIG. 1, the release film 2 is laminated on the surface (the lower surface) of the sealing sheet 1 and the obtained laminate is also capable of being wound into a roll shape.

As referred in FIG. 3D, the thickness of the sealing sheet 1 is appropriately selected according to the size of an encapsulating resin layer 9. The sealing sheet 1 has a thickness of, for example, 0.3 mm or more, or preferably 0.4 mm or more, and of, for example, 2.0 mm or less, or preferably 1.0 mm or less.

The sealing sheet 1 has a width (a length in a direction perpendicular to the lengthwise direction) of, for example, 5 mm or more, or preferably 10 mm or more, and of, for example, 30 mm or less, or preferably 20 mm or less.

The sealing sheet 1 obtained in this manner is used for the encapsulation of various industrial products. The sealing sheet 1 is preferably used for the encapsulation of multi-layered glass, or particularly preferably for the encapsulation of a solar cell panel.

Next, a solar cell panel in which the circumference end portion thereof is encapsulated by the above-described sealing sheet 1 is described with reference to FIGS. 2A to C. FIGS. 2A to C show one embodiment (an embodiment in which a sealing material is formed of four pieces) of a solar cell panel of the present invention. In FIG. 2B, an upper-side glass layer 10 is omitted so as to clearly show the relative arrangement of the sealing sheet 1.

In FIGS. 2A to C, a solar cell panel 4 includes the upper-side glass layer 10 as a glass layer, a lower-side glass layer 11 that is disposed at spaced intervals downwardly to the upper-side glass layer 10 as a support layer, a solar cell element 8 and the encapsulating resin layer 9 encapsulating the solar cell element 8 that are provided between the upper-side glass layer 10 and the lower-side glass layer 11 and are disposed at the inside of circumference end portions 5 of the upper-side glass layer 10 and the lower-side glass layer 11, and the sealing sheet 1 that is filled between the circumference end potions 5 of the upper-side glass layer 10 and the lower-side glass layer 11.

The upper-side glass layer 10 is provided at the outermost surface (the upper surface) side of the solar cell panel 4 and is formed into a generally rectangular shape in plane view. The upper-side glass layer 10 has a thickness of, for example, 0.5 to 3.2 mm.

The lower-side glass layer 11 is provided at the backmost surface (the lower surface) side of the solar cell panel 4 and is, in plane view, formed into a generally rectangular shape having the same size as that of the upper-side glass layer 10. The lower-side glass layer 11 has a thickness of, for example, 0.5 to 3.2 mm.

An example of the solar cell element 8 includes a known solar cell element such as a crystalline silicon solar cell element and an amorphous silicon solar cell element. The solar cell element 8 is formed into a generally rectangular flat plate shape and is, in plane view, disposed at the central portion of the upper-side glass layer 10 and the lower-side glass layer 11.

The solar cell element 8 is laminated on the lower surface of the upper-side glass layer 10. The thickness of the solar cell element 8 is thinner than that of the encapsulating resin layer 9. To be specific, the solar cell element 8 has a thickness of, for example, 0.15 to 0.20 mm.

The encapsulating resin layer 9 is, in plane view, formed into a generally rectangular shape that is smaller than the upper-side glass layer 10 and the lower-side glass layer 11. The encapsulating resin layer 9 encapsulates the solar cell element 8.

A material that forms the encapsulating resin layer 9 is not particularly limited. To be specific, an example of the material includes a resin such as an ethylene-vinyl acetate copolymer (EVA), polyvinyl butyral (PVB), and polyvinylidene fluoride. The encapsulating resin layer 9 has a thickness of, for example, 0.5 to 1 mm.

The sealing sheet 1 encapsulates the encapsulating resin layer 9. As shown in FIG. 2B, the sealing sheet 1 includes two longitudinal sealing materials 13 in a generally rectangular shape in plane view extending long in a longitudinal direction and two lateral sealing materials 14 in a generally rectangular shape in plane view extending long in a lateral direction and in contact with both end portions in the longitudinal direction of each of the longitudinal sealing materials 13.

The longitudinal sealing materials 13 are filled in a portion in a thickness direction of both end portions in the lateral direction of the upper-side glass layer 10 and the lower-side glass layer 11. The lateral sealing materials 14 are filled in a portion in the thickness direction of the both end portions in the longitudinal direction of the upper-side glass layer 10 and the lower-side glass layer 11.

Next a method for producing the above-described solar cell panel 4 is described with reference to FIGS. 3A to E.

In this method, first, as shown in FIG. 3A, the upper-side glass layer 10 is prepared.

Next, as shown in FIG. 3B, the solar cell element 8 is disposed on the lower surface of the upper-side glass layer 10.

Next, as shown in FIG. 3C, the encapsulating resin layer 9 is disposed.

The encapsulating resin layer 9 is disposed so as to cover the solar cell element 8 and expose the circumference end portions of the upper-side glass layer 10.

The encapsulating resin layer 9 is before compressive bonding to be described later, so that a thickness T1 thereof is set to be thicker than a thickness T3 of the sealing sheet 1. To be specific, the thickness T1 is set to be, for example, 0.4 mm or more, or preferably 0.5 mm or more, and is set to be, for example, 2.0 mm or less, or preferably 1.2 mm or less.

Next, as shown in FIG. 3D, the sealing sheet 1 including the longitudinal sealing materials 13 and the lateral sealing materials 14 described above is disposed in the above-described arrangement. The sealing sheet 1 is disposed, while being melted as required (thermally fused).

The thickness T3 of the sealing sheet 1 is thinner than the thickness T1 of the above-described encapsulating resin layer 9 (the encapsulating resin layer 9 before the compressive bonding). To be specific, the thickness T3 with respect to the thickness T1 is, for example, 50 % or more, or preferably 60 % or more, and is, for example, 90 % or less, or preferably 80 % or less. To be more specific, the thickness T3 of the sealing sheet 1 is, for example, 0.3 mm or more, or preferably 0.4 mm or more, and is, for example, 1.6 mm or less, or preferably 0.9 mm or less.

When the thickness T3 of the sealing sheet 1 is above the above-described range, there may be a case where the processability at the time of attachment to the lower-side glass layer 11 is reduced and a gas (for example, an acetic acid gas generated from EVA) generated from the encapsulating resin layer 9 and/or the air fail(s) to be released, so that bubbles remain in the encapsulating resin layer 9. On the other hand, when the thickness of the sealing sheet 1 is below the above-described range, the sealing properties of the circumference end portion 5 of the solar cell panel 4 may not be capable of being sufficiently ensured.

Thereafter, in this method, as shown in FIG. 3E, the lower-side glass layer 11 is attached to the encapsulating resin layer 9 and the sealing sheet 1.

In order to attach the lower-side glass layer 11 to the encapsulating resin layer 9 and the sealing sheet 1, the lower-side glass layer 11 is brought into contact with the lower surface of the encapsulating resin layer 9 and the lower-side glass layer 11 is compressively bonded thereto upwardly. In the compressive bonding, for example, thremocompression bonding is performed under a vacuum (a reduced pressure).

The conditions for the thermocompression bonding are as follows: a temperature of, for example, 100°C or more, or preferably 110°C or more, and of, for example, 160°C or less, or preferably 150°C or less; a pressure of, for example, 0.05 MPa or more, and of, for example, 0.5 MPa or less, or preferably 0.2 MPa or less; and a thermocompression bonding duration of, for example, one minute or more, or preferably 10 minutes or more, and of, for example, 60 minutes or less, or preferably 30 minutes or less.

The encapsulating resin layer 9 is compressed by the compressive bonding, so that a thickness T2 of the encapsulating resin layer 9 (the encapsulating resin layer 9 after the compressive bonding) is generally the same as the thickness T3 of the sealing sheet 1.

In this manner, the solar cell panel 4 in which the sealing sheet 1 is filled in the circumference end portion 5 is capable of being obtained.

The solar cell panel end-sealing composition contains a butyl rubber, a polyolefin resin having a silyl group, and a catalyst. The catalyst is at least one of a metal oxide, a metal hydroxide, and a metal complex of a transition element and the solar cell panel end-sealing composition has a flow viscosity of 500 Pa·s or more and 8000 Pa·s or less.

Thus, the solar cell panel end-sealing composition has excellent adhesive properties with respect to the solar cell panel end. When the solar cell panel end-sealing composition is used after long-term storage, the deterioration of the adhesive properties is suppressed, so that the storage stability is excellent. Furthermore, the rewinding properties of a roll-shaped sheet after long-term storage are also excellent.

The solar cell panel end-sealing sheet is formed from the above-described solar cell panel end-sealing composition into a sheet shape, so that the solar cell panel end-sealing sheet has excellent adhesive properties and excellent storage stability. Also, the solar cell panel end-sealing sheet is formed into a sheet shape, so that it is capable of easily sealing the solar cell panel.

The solar cell panel 4 includes the upper-side glass layer 10, the lower-side glass layer 11 that is disposed at spaced intervals to the upper-side glass layer 10 in the thickness direction, the solar cell element 8 and the encapsulating resin layer 9 encapsulating the solar cell element 8 that are provided between the upper-side glass layer 10 and the lower-side glass layer 11 and are disposed at the inside of the circumference end portions 5 of the upper-side glass layer 10 and the lower-side glass layer 11, and the sealing sheet 1 that is attached between the circumference end portions 5 of the upper-side glass layer 10 and the lower-side glass layer 11 so as to fix the upper-side glass layer 10 and the lower-side glass layer 11.

Thus, in the solar cell panel 4, the circumference end portion 5 thereof is surely encapsulated by the sealing sheet 1, so that a reduction in performance of the solar cell element 8 is capable of being effectively prevented over a long period of time.

In the above-described description, the encapsulating resin layer 9 is formed as a resin layer prepared from a resin. Alternatively, for example, the encapsulating resin layer 9 can be also formed as an air layer prepared from the air or an inactive gas (for example, nitrogen) or furthermore, can be also formed as a vacuum layer in a vacuum state (or a reduced pressure state).

In the above-described description, the support layer of the present invention is described as the lower-side glass layer 11. Alternatively, for example, the support layer can be also formed as a lower-side resin layer (a back sheet) 11 prepared from a resin such as a permeable resin or the like.

In the above-described description, the sealing sheet 1 is formed of four sealing materials (the two longitudinal sealing materials 13 and the two lateral sealing materials 14) in a generally rectangular shape in plane view. Alternatively, for example, as shown in FIG. 4, the sealing sheet 1 can be also formed of one sealing material.

The sealing sheet 1 can be obtained, for example, though not shown, by being formed into a generally rectangular shape in plane view with the above-described molding device and thereafter, allowing the center (the center in the longitudinal and lateral directions) thereof to be stamped out.

As shown in FIG. 5, the above-described solar cell panel 4 in FIGS. 2A to C can be also used as a frameless solar cell module 12 that fails to use a frame. Alternatively, as shown in FIGS. 6A to B, the solar cell panel 4 can be also used as a solar cell module 7 that uses a frame.

As shown in FIG. 5, the frameless solar cell module 12 can be also used as the frameless solar cell module 12 in which a known sealing material (a second sealing material) 15 is provided at the circumference end portion 5 of the solar cell panel 4.

In FIG. 5, the second sealing material 15 is, at the circumference end portion 5 of the solar cell panel 4, formed into a generally U-shape in sectional view that is open inwardly with respect to the solar cell panel 4. The second sealing material 15 is continuously formed with the circumference side surface and the upper surface of the upper-side glass layer 10, the circumference side surface of the sealing sheet material (the first sealing material) 1, and the circumference side surface and the lower surface of the lower-side glass layer 11.

In FIGS. 6A to B, the solar cell module 7 includes the solar cell panel 4, frames 16 that are provided at the circumference end portions 5 of the solar cell panel 4, and the second sealing materials 15 that are disposed therebetween.

Each of the frames 16 is provided along each of the sides of the solar cell panel 4. The frame 16 is formed into a generally U-shape in sectional view that is open inwardly with respect to the solar cell panel 4. The frame 16 is formed from, for example, a metal material (aluminum and the like) and a resin material (an acrylic resin and the like). Preferably, the frame 16 is formed from a metal material.

As shown in FIG. 6B, the frames 16 are assembled so as to form four corners by allowing the ends thereof in the lengthwise direction along each of the sides to be connected to each other and to be formed into a generally rectangular frame shape in plane view.

### Examples

While the present invention will be described hereinafter in further detail with reference to Examples and Comparative Examples, the present invention is not limited to these Examples and Comparative Examples. Values in Examples shown in the following can be replaced with the values (that is, the upper limit value or the lower limit value) described in the above-described embodiment.

### Examples 1 to 11 and Comparative Examples 1 to 6

Components other than a catalyst among the components described in Table 1 were charged into a mixing roll (rate: front of 20 rpm, rear of 15 rpm, and a gap of 1 to 2 mm) in accordance with the mixing formulation in Table 1 to be kneaded at 140°C for 18 minutes, so that a first kneaded material was prepared (a first kneading step).

Next, after cooling the prepared first kneaded material to 80°C or less, the catalyst described in Table 1 was further blended into the first kneaded material in accordance with the mixing formulation in Table 1 to be kneaded for three minutes, so that a second kneaded material (a sealing composition in Examples and Comparative Examples) was prepared (a second kneading step). In Comparative Examples 3 and 6, the second kneading step was not performed.

Next, the obtained sealing composition was compressed with a pressing device under the conditions of a pressing temperature of 80°C, a pressing pressure of 50 kPa, and a pressing duration of five minutes, so that each of sealing sheets (sealing materials, a thickness of 0.5 mm) in Examples and Comparative Examples was produced.

### <Flow Viscosity Measurement (Initial Stage)>

Each of the sealing compositions in Examples and Comparative Examples was measured in conformity with JIS K 7210 (test conditions: a load of 20 kg (21 kgf/cm²) a measurement temperature of 140°C) using a flowability evaluation device ("Flowtester CFT-500D", manufactured by Shimadzu Corporation").

The results are shown in Table 1.

### (Evaluation)

### <Peel Test>

Each of the sealing sheets in Examples and Comparative Examples was cut into pieces each having a size of 70 mm × 10 mm. One surface (the back surface) of the cut piece of the sealing sheet was lined with a PET film (a thickness of 25 µm).

Next, a white sheet float glass (manufactured by ASAHI GLASS CO., LTD., 100 mm × 40 mm) was prepared and a surface to be adhered thereof was wiped using ethanol to be dried for 30 minutes at a room temperature. The resulting glass was defined as an adherend for a peel test.

Next, the other surface (the top surface) of the sealing sheet was attached to the surface to be adhered of the white sheet float glass using a hand roller and thereafter, the obtained sheet was heated for one minute at 150°C under a vacuum condition to be subsequently further pressed for 15 seconds at a pressure of 50 kPa. Thereafter, the resulting sheet was subjected to an aging treatment for one hour under a room temperature.

Next, a peel strength at the time of peeling the sealing sheet from the white sheet float glass was measured using a universal testing machine ("AG-20 kNG", manufactured by Shimadzu Corporation) at a peel angle of 180 degrees and a peel rate of 30 mm/min. The maximum value of the measured value at this time is shown in Table 1.

A fracture mode was judged as follows: after the test, when the sealing sheet remained in the surface to be adhered, the result was evaluated as a cohesive fracture and when the sealing sheet failed to remain in the surface to be adhered, the result was evaluated as an interfacial fracture. When the interfacial fracture is confirmed, it shows that the adhesive force is insufficient.

### <Storage Stability>

Each of the sealing sheets in Examples and Comparative Examples was stored for one week under the conditions of 40°C and 92 %RH. After the storage thereof, the flow viscosity was measured (the measurement conditions were the same as that described above).

At this time, when the value of (flow viscosity after storage) / (flow viscosity at initial state) was less than two, the result was evaluated as "Good". When the value was two to three, the result was evaluated as "Poor". When the value was above three, the result was evaluated as "Bad".

### <Rewinding Properties of Roll-Shaped Sheet After Storage>

After a release film (material: PET) was laminated on one surface of each of the sealing sheets in Examples and Comparative Examples to be wound into a roll shape, both end portions in the widthwise direction thereof was cut (subjected to width processing) so as to have a predetermined width (10 mm).

Next, the roll-shaped sheet (tape) was stored for one week under the conditions of 40°C and 92 %RH. After the storage, the roll-shaped sheet was again attempted to be rewound (stretched) into a flat belt shape.

At this time, when the rewinding was impossible because a part of the sealing sheet protruded from the release film in the widthwise direction to cover the end surface of the roll-shaped sheet at the time of storage, the result was evaluated as "Bad". When a part of the sealing sheet protruded from the release film and the roll-shaped sheet was capable of being rewound into a flat belt shape, the result was evaluated as "Poor". When the roll-shaped sheet was capable of being easily rewound into a flat belt shape, the result was evaluated as "Good".

The results are shown in Table 1.

[Table 1]

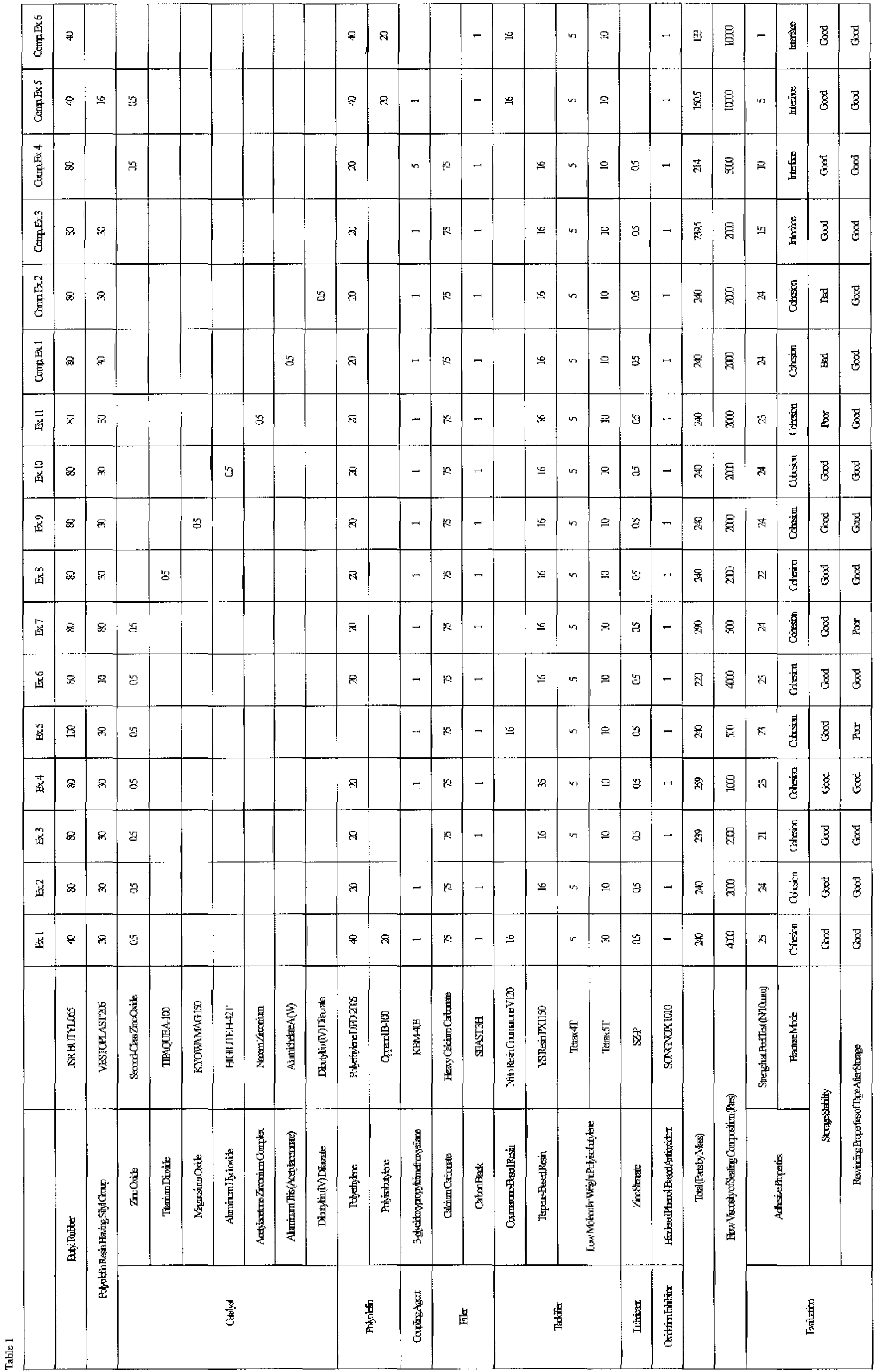

In Table 1, values for the components show the number of parts by mass unless otherwise specified.

For the components in Table 1, the details are given in the following.
JSR BUTYL 065: butyl rubber, a degree of unsaturation of 0.85 to 1.25 mol %, a Mooney viscosity of 33 (ML₁₊₈, 125°C), manufactured by JSR Corporation
VESTOPLAST 206: silyl-modified poly-α-olefin, containing a trimethoxy silyl group, a number average molecular weight of 10600, a weight average molecular weight of 38000, a softening point (a ring and ball test) of 98°C, manufactured by Evonik Industries AG
Second-Class Zinc Oxide: zinc oxide, an average particle size of 0.60 µm, manufactured by MITSUI MINING & SMELTING CO., LTD.
TIPAQUE A-100: titanium dioxide, an average particle size of 0.15 µm, manufactured by ISHIHARA SANGYO KAISHA, LTD.
KYOWA MAG 150: magnesium oxide, an average particle size of 5.6 µm, manufactured by Kyowa Chemical Industry Co., Ltd.
HIGILITE H-42T: aluminum hydroxide, an average particle size of 0.8 to 1.2 µm, manufactured by SHOWA DENKO K.K.
Nacem Zirconium: acetylacetone zirconium complex, a metal complex of a transition element, Zr(C₅H₇O₂)₄, manufactured by NIHON KAGAKU SANGYO CO., LTD.
Alumichelate A (W): aluminum tris (acetylacetonate), a metal complex of a typical element, manufactured by Kawaken Fine Chemicals Co., Ltd.
Dibutyltin (IV) Dilaurate: organic metal compound, manufactured by Wako Pure Chemical Industries, Ltd.
Polyethylene DFD-2005: crystalline polyethylene, a density of 0.92 g/cm³, manufactured by The Dow Chemical Company
Oppanol B-100: polyisobutylene, a viscosity average molecular weight of 1100000, manufactured by BASF Japan Ltd.
KBM-403: 3-glycidoxypropyltrimethoxysilane, a specific gravity of 1.07, manufactured by Shin-Etsu Chemical Co., Ltd.
Heavy Calcium Carbonate: calcium carbonate, an amount of a residue on a 45 µm sieve of 0.5 % or less (in conformity with JIS K 5101), manufactured by MARUO CALCIUM CO., LTD.
SEAST 3H: carbon black, an average particle size of 27 nm, manufactured by Tokai Carbon Co., Ltd.
Nitto Resin Coumarone V120: coumarone-indene copolymer resin, a softening point (a deflection temperature under load) of 120°C, manufactured by NITTO CHEMICAL CO., LTD.
YS Resin PX1150: terpene hydrocarbon resin, a softening point (a deflection temperature under load) of 110 to 120°C, manufactured by YASUHARA CHEMICAL CO., LTD.
Tetrax 4T: low molecular weight polyisobutylene, a viscosity average molecular weight of 40000, a density of 0.92 g/cm³ (at 15°C), manufactured by JX Nippon Oil & Energy Corporation
Tetrax 5T: low molecular weight polyisobutylene, a viscosity average molecular weight of 50000, a density of 0.92 g/cm³ (at 15°C), manufactured by JX Nippon Oil & Energy Corporation
SZ-P: zinc stearate, a melting point of 125°C, manufactured by NOF CORPORATION
SONGNOX 1010: hindered phenol-based antioxidant, manufactured by SAKAI CHEMICAL INDUSTRY CO., LTD.

## Claims

1. A solar cell panel end-sealing composition comprising:
a butyl rubber, a polyolefin resin having a silyl group, and a catalyst, wherein
the catalyst is at least one of a metal oxide, a metal hydroxide, and a metal complex of a transition element and
the solar cell panel end-sealing composition has a flow viscosity at 140°C of 500 Pa·s or more and 8000 Pa·s or less.

2. The solar cell panel end-sealing composition according to claim 1, wherein
the polyolefin resin having a silyl group has a number average molecular weight of 5000 or more and 25000 or less.

3. The solar cell panel end-sealing composition according to claim 1, wherein
a metal constituting the metal oxide is at least one selected from the group consisting of magnesium, calcium, titanium, zirconium, iron, nickel, zinc, aluminum, and cerium.

4. The solar cell panel end-sealing composition according to claim 1, wherein
a metal constituting the metal hydroxide is at least one selected from the group consisting of magnesium, calcium, manganese, iron, copper, zinc, and aluminum.

5. The solar cell panel end-sealing composition according to claim 1, wherein
a metal constituting the metal complex of a transition element is at least one selected from the group consisting of titanium, zirconium, iron, and nickel.

6. The solar cell panel end-sealing composition according to claim 1, further comprising a silane coupling agent.

7. The solar cell panel end-sealing composition according to claim 1, further comprising a polyolefin resin failing to have a silyl group is further contained.

8. The solar cell panel end-sealing composition according to claim 7, wherein
the polyolefin resin failing to have a silyl group is at least one selected from the group consisting of polyethylene, polypropylene, and an ethylene-propylene copolymer.

9. A solar cell panel end-sealing sheet formed from a solar cell panel end-sealing composition into a sheet shape, wherein
the solar cell panel end-sealing composition comprises:
a butyl rubber, a polyolefin resin having a silyl group, and a catalyst, and
the catalyst is at least one of a metal oxide, a metal hydroxide, and a metal complex of a transition element and
the solar cell panel end-sealing composition has a flow viscosity at 140°C of 500 Pa·s or more and 8000 Pa·s or less.

10. A solar cell panel comprising:
a glass layer,
a support layer disposed at spaced intervals to the glass layer in a thickness direction,
a solar cell element and an encapsulating resin layer encapsulating the solar cell element provided between the glass layer and the support layer and disposed at the inside of ends of the glass layer and the support layer, and
a solar cell panel end-sealing sheet attached between the ends of the glass layer and the support layer so as to fix the glass layer and the support layer, wherein
the solar cell panel end-sealing sheet is formed from a solar cell panel end-sealing composition into a sheet shape, and
the solar cell panel end-sealing composition comprises:
a butyl rubber, a polyolefin resin having a silyl group, and a catalyst, and
the catalyst is at least one of a metal oxide, a metal hydroxide, and a metal complex of a transition element and
the solar cell panel end-sealing composition has a flow viscosity at 140°C of 500 Pa·s or more and 8000 Pa·s or less.
